# EUROPEAN PATENT APPLICATION

(11) **EP 1 675 169 A1**
(43) Date of publication of application: **28.06.2006**
(21) Application number: 04792014.5
(22) Date of filing: 04.10.2004
(51) Int. Cl.: H01L 21/762, H01L 27/12, H01L 29/786, H01L 21/336

(54) **SEMICONDUCTOR SUBSTRATE, SEMICONDUCTOR DEVICE AND PROCESS FOR PRODUCING SEMICONDUCTOR SUBSTRATE**

(30) Priority: 10.10.2003 JP 2003352692
(71) Applicant: TOKYO INSTITUTE OF TECHNOLOGY, Tokyo 152-8550 (JP)
(72) Inventor: SAKAI, Tetsushi, c/o Tokyo Institute of Technology, Yokohama-shi, Kanagawa 226-8503 (JP); OHMI, Shunichiro, c/o Tokyo Inst. of Technology, Yokohama-shi, Kanagawa 226-8503 (JP); YAMAZAKI, Takashi, c/o Tokyo Inst. of Technology, Yokohama-shi, Kanagawa 226-8503 (JP)
(74) Representative: Stebbing, Timothy Charles
(86) International application number: PCT/JP2004/014603
(87) International publication number: WO 2005/036638

(57) **Abstract**

An opening 35 is formed on an assembly having a silicon germanium layer 32, a silicon layer 33, and a silicon oxide layer 34 sequentially formed on a silicon basis material 31. An additional silicon oxide layer 36 is formed so as to cover the silicon oxide layer 34 and an inner surface of the opening 35. Then, the silicon germanium layer 32 is removed by etching, and a thermal oxidation treatment and an annealing treatment are sequentially performed on the silicon basis material 31 and the silicon layer 33 to form thermal oxidation layers 37 and 38. Then, a flat film 39 is formed for flat treatment to manufacture a semiconductor substrate 10 having an island part 12 made of silicon buried in an insulation component 13 made of silicon oxide. This allows for easily forming a high-integration CMOSLSI based on inter-element isolation, and sufficiently reducing the SOI layer and the BOX layer in thickness, thereby preventing the short channel effect as well as forming the SOI layer and the BOX layer in multi-layers.

## Description

### [TECHNICAL ART]

The present invention relates to a semiconductor substrate, a semiconductor device, and a manufacturing method for the semiconductor substrate which allow for manufacturing with high density a basic element such as MOS transistors constituting an LSI or the like.

### [TECHNOLOGICAL BACKGROUND]

Conventionally, in providing integrated MOS transistors at a high density to manufacture a high-integration LSI, LOCOS isolation or trench isolation (shallow trench and deep trench) is provided on a SOI substrate to electrically divide a SOI layer into a plurality of areas with a silicon oxide, so that a MOS transistor is formed in each of these divided multiple areas, with the elements isolated from each other.

On the other hand, to prevent a short channel effect involved in applying finer design rules to CMOSLSIs as described above, it is necessary to reduce the thickness of the SOI layer and a BOX layer (a buried SiO₂ layer) in the SOI substrate. According to a conventional SIMOX, the BOX layer is formed by ion implantation. However, in forming a SOI layer of high quality, there exists a certain optimal range for the amount of ion implantation (an oxygen ion dose rate of about 4×10¹⁷ ions/cm²), and thus the BOX layer could not be sufficiently reduced in thickness.

On the other hand, in the ELTRAN (Canon Inc.) and UNIBOND (registered trademark), the BOX layer is defined by the thickness of SiO₂ layers provided in two wafers used for being affixed to each other. Thus, a reduction in the thickness of the BOX layer would make it difficult to prevent defects. Furthermore, since the SOI layer is eventually subjected to a CMP process, the thickness of the SOI layer depends on the uniformity in the CMP. Thus, a reduction in the thickness of the SOI layer would not ensure the uniformity of the SOI layer, thereby causing the MOS transistor to have a significant variation in threshold voltage Vth and thus operate as an LSI with difficulty. It is also difficult to prevent crystal defects at the time of the CMP as the SOI layer is extremely reduced in thickness.

As described above, there is a problem that a reduction in thickness of the SOI layer and the BOX layer would make it difficult to electrically well divide the SOI layer, so that the originally intended high-integration CMOSLSI cannot be manufactured.
[Patent Document 1] Japanese Unexamined Patent Application Publication No. Hei 9-161477

### [DISCLOSURE OF THE INVENTION]

### [PROBLEMS TO BE SOL VED BY THE INVENTION]

It is an object of the present invention to provide a novel semiconductor substrate, semiconductor device, and manufacturing method for the semiconductor substrate, which enables easy formation of a high-integration CMOSLSI based on inter-element isolation and sufficient reduction in the thickness of the SOI layer and the BOX layer, thereby preventing the short channel effect.

### [MEANS TO SOL VE THE PROBLEMS]

To achieve the aforementioned object, the present invention provides a semiconductor substrate which includes a basis material made of silicon and a plurality of island parts made of silicon that are electrically insulated from the basis material as well as from each other above the basis material. The present invention provides a semiconductor substrate which includes island parts located at different distances from the basis material. The present invention further provides a semiconductor substrate which includes an island part electrically insulated from the basis material and an island part in contact with the basis material.

According to the semiconductor substrate of the present invention, a plurality of island parts made of silicon are provided above the silicon basis material so as to be electrically insulated from the basis material as well as from each other. Accordingly, it is made possible to easily form an inter-element isolated LSI by manufacturing predetermined basic elements such as MOS transistors on each of the plurality of island parts and connecting them by multi-level interconnection.

Furthermore, controlling the width and layout density of the plurality of island parts appropriately makes it possible to control the size and density of MOS transistors to be formed appropriately, thereby providing a CMOSLSI at a desired integration density.

Furthermore, according to the semiconductor substrate of the present invention, the plurality of island parts can be formed in a single plane generally parallel to the main surface of the basis material. Accordingly, the thickness of the so-called BOX layer mentioned above is determined as the sum of the thicknesses of both the thermal oxide films which are formed between the main surface of the basis material and the main surface of the island parts facing to the basis material, sufficiently reducing the distance in accordance with a manufacturing method to be described in detail below. Furthermore, the thickness of the so-called SOI layer mentioned above is determined from the distance between the main surface of the island parts facing to the basis material and the main surface of the island parts located opposite to the basis material, reducing the distance sufficiently in accordance with a manufacturing method to be described in detail below. Accordingly, it is possible to sufficiently prevent the short channel effect.

Furthermore, according to the semiconductor substrate of the present invention, the plurality of island parts are formed in a plurality of planes generally parallel to the main surface of the basis material, and as a result, can also be formed in multi-stages or multi-layers above the basis material. Accordingly, basic elements such as MOS transistors may be manufactured on the plurality of island parts and connected to each other by multi-level interconnection, thereby making it possible to manufacture an LSI at a significantly high integration density.
According to a preferred embodiment of the present invention, the plurality of island parts can be configured to be buried in an insulation component such as a silicon oxide by a manufacturing method to be described in detail below.

Furthermore, according to a semiconductor substrate of the present invention, the island parts located at mutually different distances from the basis material are formed, thereby readily mounting elements operating at high speeds and those having high breakdown voltages on the same semiconductor substrate. For example, this makes it possible to manufacture higher-performance analog/digital mixable LSIs or the like (semiconductor devices) at low costs.
Furthermore, according to the semiconductor substrate of the present invention, an island part electrically insulated from the basis material and an island part in contact with the basis material are formed, which makes it possible to readily form the so-called SOI area and a bulk area on the semiconductor substrate. That is, the semiconductor substrate can be partially formed in a SOI structure. For example, this makes it possible to mount a DRAM on the SOI substrate together, which would be otherwise difficult to mount, thus improving a performance of the semiconductor device.
Other features and advantages of the present invention and a manufacturing method according to the present invention will be described below in more detail in the

### DESCRIPTION OF THE PREFERRED EMBODIMENTS.

### [ADVANTAGEOUS EFFECT OF THE INVENTION]

As described above, the present invention can provide a novel semiconductor substrate, semiconductor device and manufacturing method for the semiconductor substrate, which make it possible to easily manufacture a high-integration CMOSLSI based on inter-element isolation and sufficiently reduce the SOI layer and the BOX layer in thickness, thereby preventing a short channel effect.

### [BRIEF DESCRIPTION OF THE DRAWINGS]

[Fig.1] Fig. 1 is a schematic cross-sectional view showing a configuration according to a first embodiment of the present invention;
[Fig. 2] Fig. 2 is a schematic cross-sectional view showing a configuration according to a second embodiment of the present invention;
[Fig. 3] Fig. 3 is an explanatory process diagram showing a manufacturing method for the semiconductor substrate shown in Fig. 1;
[Fig.4] Fig. 4 is a cross-sectional view showing a process next to the process shown in Fig. 3;
[Fig.5] Fig. 5 is a cross-sectional view showing a process next to the process shown in Fig. 4;
[Fig.6] Fig. 6 is a cross-sectional view showing a process next to the process shown in Fig. 5;
[Fig.7] Fig. 7 is a cross-sectional view showing a process next to the process shown in Fig. 6;
[Fig.8] Fig. 8 is a cross-sectional view showing a process next to the process shown in Fig. 7;
[Fig.9] Fig. 9 is a cross-sectional view showing a process next to the process shown in Fig. 8;
[Fig.10] Fig. 10 is a cross-sectional view showing a main portion of the semiconductor device manufactured using the semiconductor substrate according to the first embodiment;
[Fig.11] Fig. 11 is an explanatory process diagram showing a manufacturing method for the semiconductor substrate shown in Fig. 2;
[Fig.12] Fig. 12 is a cross-sectional view showing a process next to the process shown in Fig. 11;
[Fig.13] Fig. 13 is a cross-sectional view showing a process next to the process shown in Fig. 12;
[Fig. 14] Fig. 14 is a cross-sectional view showing a process next to the process shown in Fig. 13;
[Fig.15] Fig. 15 is a cross-sectional view showing a process next to the process shown in Fig. 14;
[Fig. 16] Fig. 16 is a cross-sectional view showing a process next to the process shown in Fig. 15;
[Fig.17] Fig. 17 is a cross-sectional view showing a process next to the process shown in Fig. 16;
[Fig.18] Fig. 18 is a cross-sectional view showing a main portion of a semiconductor device manufactured using the semiconductor substrate according to the second embodiment;
[Fig.19] Fig. 19 is a schematic cross-sectional view showing a configuration according to a third embodiment of the present invention;
[Fig.20] Fig. 20 is an explanatory process diagram showing a manufacturing method for the semiconductor substrate shown in Fig. 19;
[Fig.21] Fig. 21 is a cross-sectional view taken along the line A-A' and the line B-B' of Fig. 20;
[Fig.22] Fig. 22 is a cross-sectional view showing a process next to the process shown in Fig. 20;
[Fig.23] Fig. 23 is a cross-sectional view showing a process next to the process shown in Fig. 22;
[Fig.24] Fig. 24 is a cross-sectional view showing a process next to the process shown in Fig. 23;
[Fig.25] Fig. 25 is a schematic cross-sectional view showing a configuration according to a fourth embodiment of the present invention;
[Fig.26] Fig. 26 is an explanatory process diagram showing a manufacturing method for the semiconductor substrate shown in Fig. 25;
[Fig.27] Fig. 27 is a cross-sectional view showing a process next to the process shown in Fig. 26;
[Fig.28] Fig. 28 is a cross-sectional view showing a process next to the process shown in Fig. 27;
[Fig.29] Fig. 29 is a cross-sectional view showing a process next to the process shown in Fig. 28;
[Fig.30] Fig. 30 is a schematic cross-sectional view showing a configuration according to a fifth embodiment of the present invention;
[Fig.31] Fig. 31 is a cross-sectional view showing a main portion of a semiconductor device manufactured using the semiconductor substrate according to the fifth embodiment;
[Fig.32] Fig. 32 is a schematic cross-sectional view showing a configuration according to a sixth embodiment of the present invention;
[Fig.33] Fig. 33 is a cross-sectional view showing a main portion of a semiconductor device manufactured using the semiconductor substrate according to the sixth embodiment;
[Fig.34] Fig. 34 is an explanatory process diagram showing a manufacturing method for a semiconductor substrate according to a seventh embodiment of the present invention; and
[Fig.35] Fig. 35 is an explanatory process diagram showing a manufacturing method for a semiconductor substrate according to an eighth embodiment of the present invention.

### [DESCRIPTION OF THE PREFERRED EMBODIMENTS]

Now, the present invention will be described below in more detail in accordance with the embodiments.

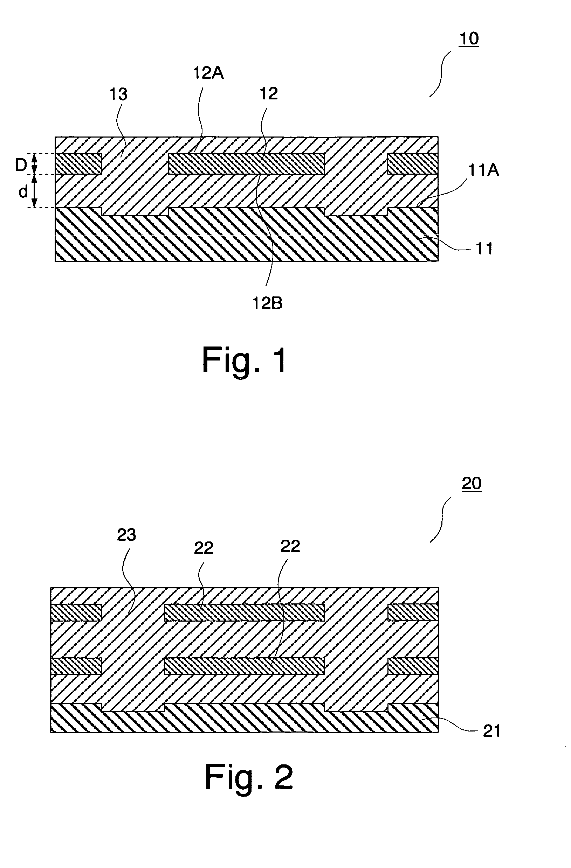

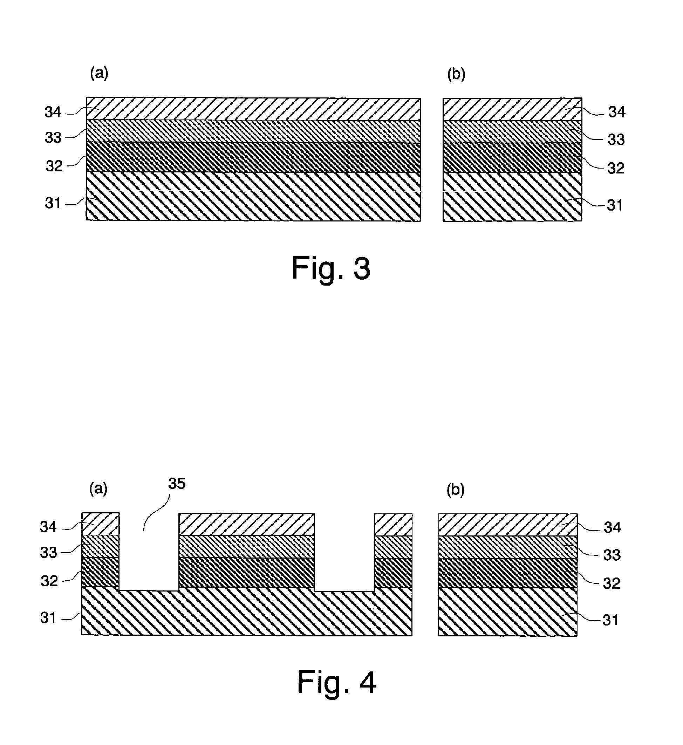

Fig. 1 is a schematic cross-sectional view showing a configuration according to a first embodiment of the present invention. A semiconductor substrate 10 shown in Fig. 1 has island parts 12 of silicon that are buried in an insulation component 13 above convex parts of an uneven part formed on a surface of a silicon basis material 11. A dent part of the uneven part is formed through an etching process to be described later with reference to Fig. 4. The convex part is formed of a portion that is not etched. As a result, the island parts 12 are electrically insulated from the basis material 11, and the island parts are also electrically insulated from each other. Additionally, the island parts 12 are formed in a plane generally parallel to a main surface 11A of the basis material 11, thus being formed in one stage or a single layer. The insulation component 13 can be formed of a silicon oxide or the like depending on the manufacturing methods to be described below.

According to the semiconductor substrate 10 shown in Fig. 1, it is possible to manufacture a predetermined LSI structure (semiconductor device) by forming basic elements such as MOS transistors at the island parts 12 and connecting them by multi-level interconnection.

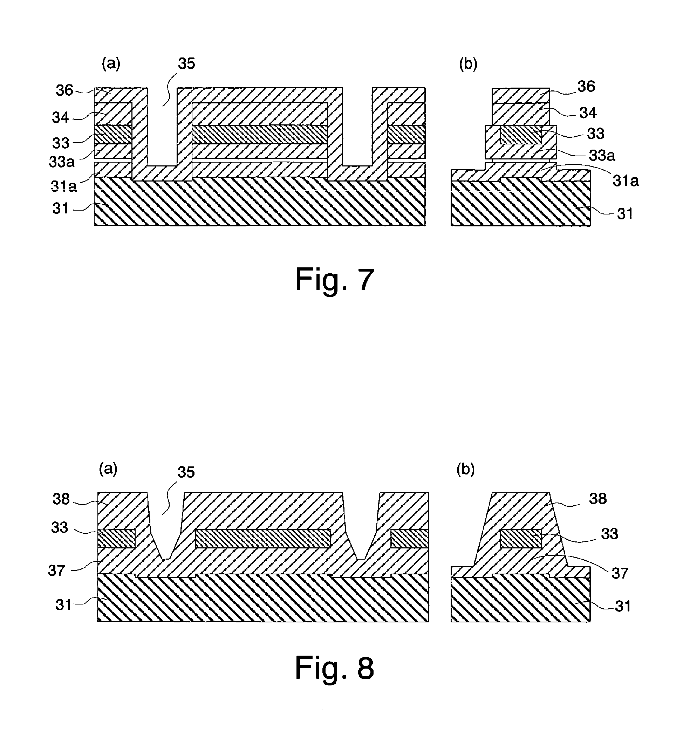

The width of the island part 12 (the lateral width of a silicon layer 33 in Fig. 8(b) to be discussed later) is determined based on the size of the basic element to be formed but is preferably formed to be about 2 µm or less in width or about 4 µm or less in width.

Furthermore, the distance d between the main surface 11A of the basis material 11 and a main surface 12B of the island part 12 opposed to the basis material 11 can be set to about 3 nm to 200 nm depending on the manufacturing methods to be described below in detail. Since the distance d corresponds to the thickness of the so-called BOX layer in the SOI substrate, such a BOX layer reduced in thickness allows for sufficiently preventing the short channel effect of an ultra-fine MOS transistor that is included in an LSI manufactured using the semiconductor substrate 10 shown in Fig. 1.

Furthermore, the distance D between a main surface 12A of the island parts 12 and the main surface 12B of the island part 12 opposed to the basis material 11 can be set to about 2 nm to 150 nm depending on the manufacturing methods to be also described below in detail. Since the distance D corresponds to the thickness of the so-called SOI layer in the SOI substrate, such a SOI layer reduced in thickness allows for sufficiently preventing the short channel effect of an ultra-fine MOS transistor that is included in an LSI manufactured using the semiconductor substrate 10 shown in Fig. 1.

According to a conventional SIMOX or the like, it is difficult to form a BOX layer in a thickness less than about 100 nm. It is thus impossible to sufficiently prevent the short channel effect of an ultra-fine gate length MOS transistor when compared with the semiconductor substrate of the present invention.

Fig. 2 is a schematic cross-sectional view showing a configuration according to a second embodiment of the present invention. A semiconductor substrate 20 shown in Fig. 2 has a plurality of island parts 22 of silicon that are buried in an insulation component 23 above a silicon basis material 21. As a result, the island parts 22 are electrically insulated from the basis material 21, and the island parts are also electrically insulated from each other. Additionally, the island parts 22 are formed within a plurality of planes generally parallel to the main surface 11 A of the basis material 11, thus being formed in multi-stages or multi-layers. The insulation component 23 can be formed of a silicon oxide or the like depending on the manufacturing methods to be described below.

According to the semiconductor substrate 20 shown in Fig. 2, it is also possible to manufacture a predetermined LSI structure by forming basic elements such as MOS transistors at the island parts 22 and connecting them by multi-level interconnection. When compared with the semiconductor substrate 10 shown in Fig. 1, the semiconductor substrate 20 shown in Fig. 2 has the island parts formed in multi-layers and thus makes it possible to manufacture a higher-integration LSI (semiconductor device). It is possible to manufacture a MOS transistor having channels formed in multi-layers (ML-MOS, i.e., multi-layer channel MOS) using the multi-layer island parts, and manufacture a larger ON-current transistor on a smaller area than a conventionally required area. The ML-MOS is described in detail in "Proposal of a multi-layer channel MOSFET: the application selective etching for Si/SiGe stacked layers", by D. Sasaki, et al, Applied Surface Science, vol 234, pp. 100 to 103, 2003. Additionally, the lower island part can be used as part of wiring.

Furthermore, according to the semiconductor substrate shown in Fig. 2, it is possible to form a MOS transistor at the upper island part and apply a potential to the lower island part, thereby controlling the threshold voltage of the MOS transistor in the upper island part. In this case, since the present invention can significantly reduce the thickness of an insulator film between the upper and lower island parts, it is possible to apply a lower voltage to the lower island part and thus reduce the power consumption of the LSI.

On the other hand, signal amplitudes tend to be reduced with decreasing LSI power supply voltages, thereby causing crosstalk through the silicon substrate to be significantly problematic. In particular, for an analog/digital mixable LSI, it is critical to reduce crosstalk through the silicon substrate along with an increase in speed and density and a decrease in power supply voltage. It is possible to significantly reduce crosstalk by fixing the lower island part to a circuit reference potential such as a ground potential.

Now, a description is given to a manufacturing method for the semiconductor substrate according to the first embodiment of the present invention. Fig. 3 to Fig. 9 are explanatory process diagrams showing a manufacturing method for the semiconductor substrate 10 shown in Fig. 1. Fig. 3(a) to Fig. 9(a) are views showing a lateral cross section of a semiconductor substrate assembly being manufactured corresponding to the configuration of the semiconductor substrate 10 shown in Fig. 1. Fig. 3 (b) to Fig. 9 (b) are views showing a transverse cross section taken along a line passing through the center of the semiconductor substrate assembly shown in Fig. 3(a) to Fig. 9(a), respectively.

First, as shown in Fig. 3, a silicon germanium layer 32 is formed, for example, in a thickness of 2 nm to 120 nm by LP-CVD on a silicon basis material 31. In this case, silicon may be thinly formed on the silicon basis material 31, and the silicon germanium layer 32 may then be formed. Then, the silicon layer 33 is formed, for example, in a thickness of 5 nm to 200 nm by LP-CVD on the silicon germanium layer 32. Then, a silicon oxide layer 34 is formed, for example, in a thickness of 50 nm to 500 nm by low-temperature CVD (400 deg. C) on the silicon layer 33. In this case, to minimize unintended etching with nitrate fluoride, the silicon oxide layer may also be a silicon nitride layer formed on the silicon oxide layer.

The silicon germanium layer 32 preferably contains a P-type dopant such as boron (B). The doping concentration is preferably about 1×10¹⁹ cm⁻³ or more. It is also preferable to contain germanium in a concentration of 5% to 50%. This allows the etching rate of the silicon germanium layer 32 for an etchant such as a nitrate fluoride solution shown below to be sufficiently higher than the etching rate of the silicon layer 33 for the etchant, for example, on the order of two or more. Accordingly, when the semiconductor substrate assembly including the basis material 31 to the silicon oxide layer 34 is subjected to an etching treatment using the etchant, this makes it possible to dissolve and remove only the silicon germanium layer 33 without dissolving and removing the silicon layer 33. The foregoing description was directed to a P-type dopant, however, an n-type dopant such as phosphorus may also be employed, and no dopant may be added to the silicon germanium layer 32. In this case, the silicon germanium layer 32 may be formed as a strain relaxation silicon germanium layer and the silicon layer 33 may be formed as a strained silicon layer. This allows the island parts 12 of Fig. 1 to have an increased carrier mobility, thus providing an enhanced electric characteristic to the MOSFET formed at the island part 12.

Then, as shown in Fig. 4, the semiconductor assembly is processed by photolithography and etching, thereby removing the silicon germanium layer 32 to the silicon oxide layer 34 in the direction of thickness as well as partially removing a surface portion of the basis material 31 to thereby form an opening 35.

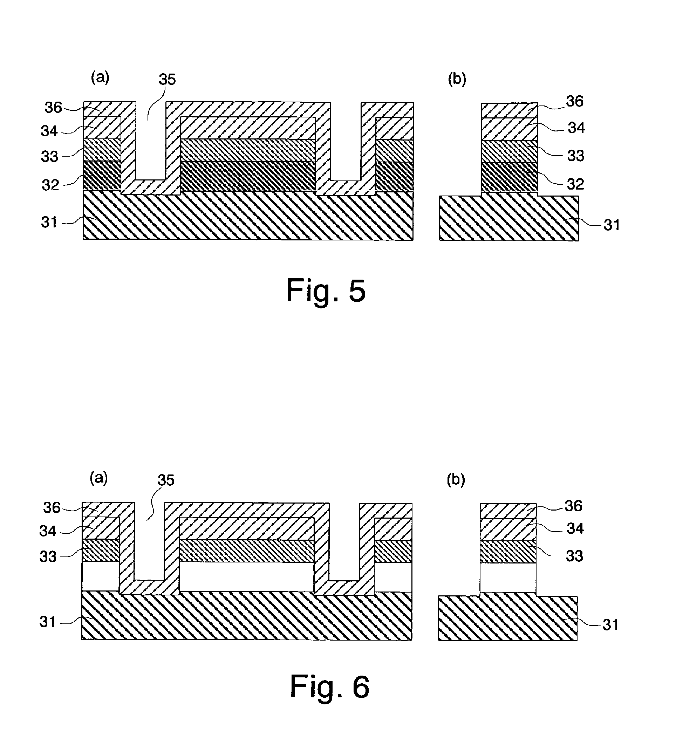

Then, as shown in Fig. 5, for example, by low-temperature CVD (400 deg. C) or the like, an additional silicon oxide layer 36 is formed, for example, in a thickness of about 100 nm to 1000 nm so as to cover a surface of the silicon oxide layer 34 and an inner surface of the opening 35. After the silicon oxide layer 36 is formed, a thermal treatment may also be carried out, for example, at about 700 deg. C. The silicon oxide layer 34 may also be removed before the silicon oxide layer 36 is formed. To lower the softening temperature of the silicon oxide layer, an impurity such as boron or phosphorus may also be added to the silicon oxide layer 36. Thereafter, the resulting semiconductor substrate assembly may be processed by photolithography and etching, thereby removing the silicon germanium layer 32 to the additional silicon oxide layer 36 in the direction of thickness as well as removing a surface portion of the basis material 31 to manufacture a trim-like stacked structure.

Then, as shown in Fig. 6, using the aforementioned nitrate fluoride based etchant, the semiconductor substrate assembly shown in Fig. 5 is subjected to an etching treatment to remove only the silicon germanium layer 32. The constituent of the etchant can be, for example, as HNO₃:H₂O:HF = 60:60:1 or HNO₃:H₂O:HF = 120:60:1. The selectivity provided by this etchant between the silicon layer 33 and the silicon germanium layer 32 is about 1:100. That is, the etching rate of the silicon germanium layer 32 is 100 times higher than that of the silicon layer 33. This high selectivity ensures that the silicon layer 33 remains when the silicon germanium layer 32 has been completely etched. Accordingly, although the silicon germanium layer 32 is etched a great deal, it is possible to control the lateral width of the silicon layer 33 of Fig. 6 (b) to about 2 µm or less or about 4 µm or less. It is also possible to mix an appropriate amount of acetic acid or the like into the nitrate fluoride etchant. Additionally, in this case, it is possible to use an ammonia / hydrogen peroxide based etchant. For example, the mixing ratio can be as NH₄:H₂O₂:H₂O = 1:5:50. Additionally, as dry etching, the etching can be conducted using an oxygen / fluorine based gas.

Then, as shown in Fig. 7, the semiconductor substrate assembly shown in Fig. 6 is subjected to a thermal oxidation treatment to thermally oxidize a surface portion of the basis material 31 and a surface portion of the silicon layer 33 opposed to the basis material 31, thereby forming oxidized surface portions 31 a and 33a. The thickness of these oxidized surface portions can be 1.5 nm to 100 nm. Additionally, the thermal oxidation treatment can be conducted by a wet process such as wet O₂ oxidation. Before being formed, as a pre-process, the oxidized surface portions 31a and 33a may be subjected to sacrificial oxidation and thereafter removed.

Then, as shown in Fig. 8, the semiconductor substrate assembly shown in Fig. 7 is subjected to an annealing treatment so as to make the silicon oxide layer 36 soft to flow allowing the oxidized surface portion 33a to be brought into contact with the oxidized surface portion 31 a and glued to each other, thereby forming a thermally oxidized silicon layer 37. At this time, the silicon oxide layers 34 and 36 are glued together more firmly to form a silicon oxide layer 38. The annealing treatment is preferably carried out within a temperature range of 850 deg. C to 1350 deg. C. When an impurity such as boron or phosphorus is added to the silicon oxide layer 36, the temperature at which the softening and flowing take place is lowered, and thus the annealing treatment may be performed at a lower temperature in the temperature range for the aforementioned annealing treatment.

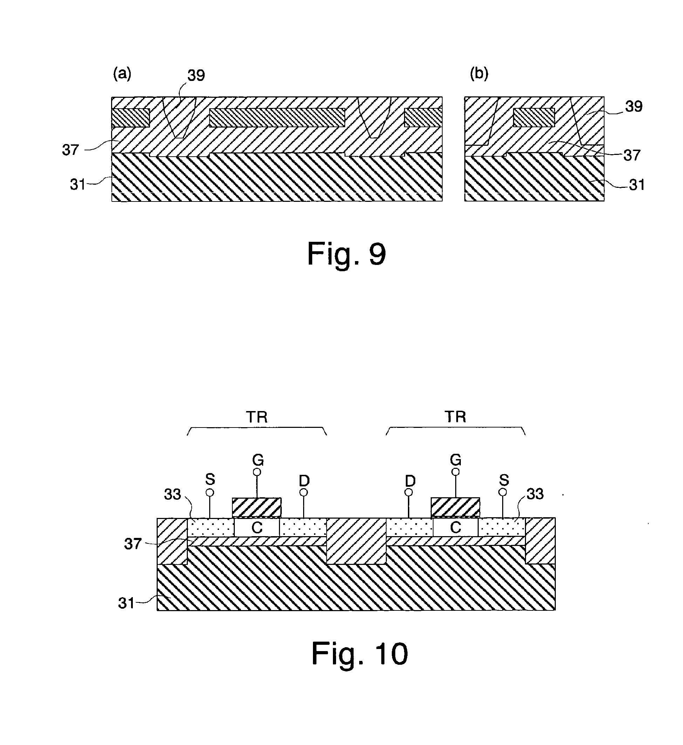

Then, as shown in Fig. 9, a silicon oxide film 39 is formed by CVD so as to bury the opening 35 of the semiconductor substrate assembly shown in Fig. 8 and flattened by CMP or the like, thereby providing the semiconductor substrate 10 shown in Fig. 1.

In the aforementioned manufacturing method, the thickness of the BOX layer in the SOI substrate, which is defined by the distance d shown in Fig. 1 between the main surface 11A of the basis material 11 and the main surface 12B of the island part 12, is to be determined by the thickness of the thermally oxidized silicon layer 37. Additionally, the thickness of the SOI layer in the SOI substrate, which is defined by the distance D between the main surface 12A and the other main surface 12B of the island part 12, is determined by the thickness of the silicon layer 33 formed by LP-CVD and the amount of thermal oxidation that is provided thereafter. Accordingly, by providing a sufficiently small setting to the thickness of these layers, it would be possible to reduce the thickness of the BOX layer and the SOI layer very easily to a predetermined thickness without relying on processing such as CMP.

Furthermore, the conventional UNIBOND and ELTRAN require two wafers for manufacturing a semiconductor substrate; however, the manufacturing method of the present invention may have to use only one wafer. Additionally, for the conventional SOI substrate, the manufacture of the substrate and the inter-element isolation were conducted in separate processes; however, the manufacturing method of the present invention allows for conducting the manufacture of the substrate and the inter-element isolation in the same process. Accordingly, it is possible to sufficiently reduce the fabrication costs of the semiconductor substrate of interest.
Fig. 10 shows a main portion of a semiconductor device manufactured using the semiconductor substrate of the first embodiment. The semiconductor device has a plurality of MOS transistors TR manufactured on the silicon oxide layer 37 (BOX layer). Each transistor TR is formed of a source region S, a drain region D, and a channel region C, which are manufactured by selectively implanting a dopant such as boron, phosphorus, or arsenic into the silicon layer 33, and a gate electrode G manufactured on the channel region C via a gate insulator film. Furthermore, although not shown in the drawings, the source region S, the drain region D, and the gate electrode G are connected to wiring (signal lines and power supply wirings) formed using a plurality of wiring layers. The wiring layers are laminated on the transistor TR via an interlayer insulator.

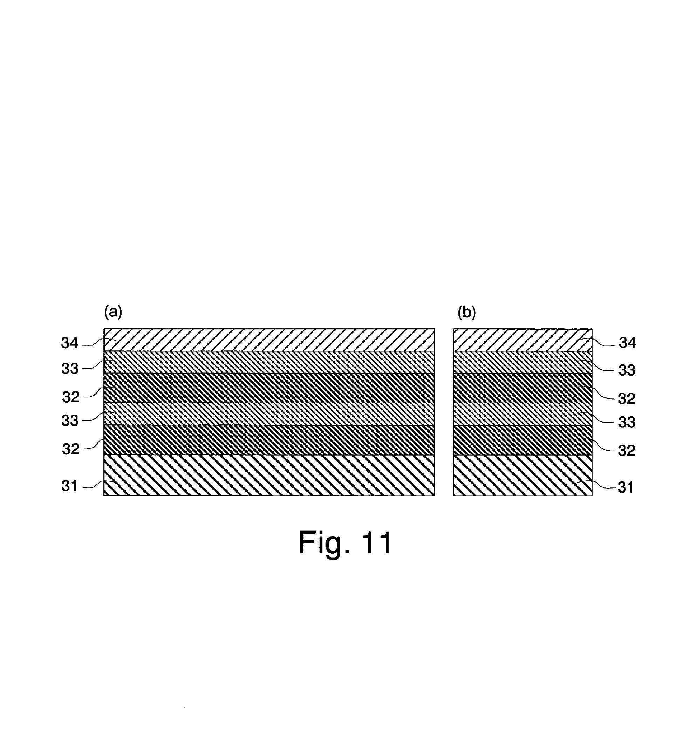

Fig. 11 to Fig. 17 are explanatory process diagrams showing a manufacturing method for the semiconductor substrate 20 shown in Fig. 2 according to the second embodiment of the present invention. Fig. 11 (a) to Fig. 17 (a) are views showing a lateral cross section of a semiconductor substrate assembly being manufactured corresponding to the configuration of the semiconductor substrate 20 shown in Fig. 2. Fig. 11 (b) to Fig. 17 (b) are views showing a transverse cross section taken along a line passing through the center of the semiconductor substrate assembly shown in Fig. 11 (a) to Fig. 17 (a), respectively. Like reference numerals are used for the same components as those of Fig. 3 to Fig. 9.

The semiconductor substrate 20 shown in Fig. 2 can be manufactured basically in the same manner as the semiconductor substrate shown in Fig. 1. First, as shown in Fig. 11, the silicon germanium layer 32 and the silicon layer 33 are alternately laminated on the silicon basis material 31 in a manner such that the silicon germanium layer is located at the bottom layer and the silicon layer 33 is located at the top layer. In Fig. 11, the silicon germanium layer 32 and the silicon layer 33 are formed each in two layers. The silicon germanium layer 32 and the silicon layer 33 are preferably formed also by LP-CVD as in the foregoing, and preferably formed in a thickness of 2 nm to 120 nm and 5 to 200 nm, respectively. Additionally, in this case, the silicon germanium layer 32 may also be formed as a strain relaxation silicon germanium layer, and the silicon layer 33 may be formed as a strained silicon layer. This allows the silicon island parts 22 of Fig. 2 to have an increased carrier mobility, thus providing an enhanced electric characteristic to the MOSFET formed at the island part 22.

Then, the silicon oxide layer 34 is formed, for example, by CVD in a thickness of 50 nm to 500 nm on the silicon layer 33 located at the top layer. In this case, to minimize unintended etching with nitrate fluoride, the silicon oxide layer may be a silicon nitride layer formed on the silicon oxide layer.

As described above, the silicon germanium layer 32 preferably contains a dopant such as boron (B) in a concentration of 1×10¹⁹ cm⁻³ or more, and germanium in a concentration of 5% to 50%. The dopant may also be an n-type dopant such as phosphorus or no dopant may be added to the silicon germanium layer 32.

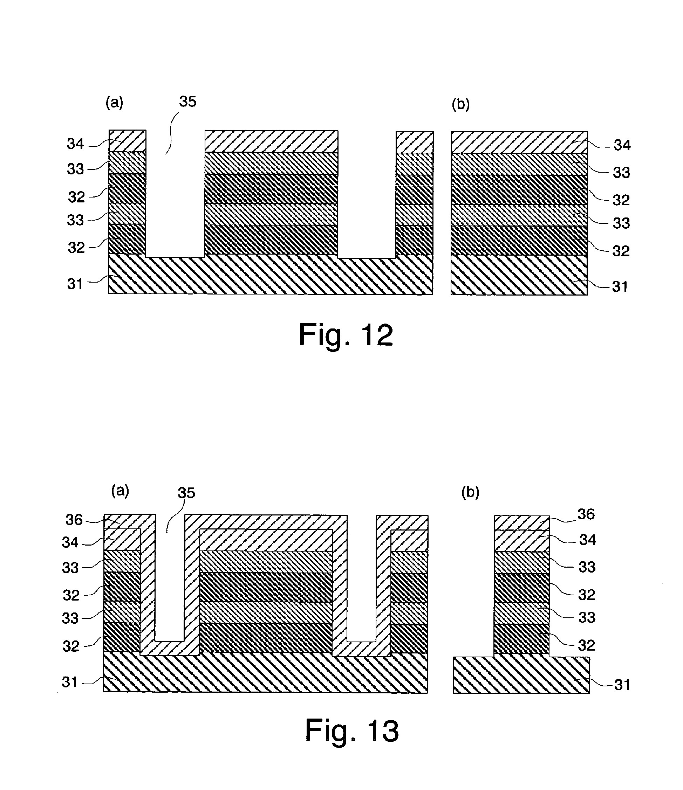

Then, as shown in Fig. 12, the semiconductor assembly is processed by photolithography and etching, thereby removing the silicon germanium layer 32 at the bottom layer to the silicon oxide layer 34 in the direction of thickness as well as partially removing a surface portion of the basis material 31 to form the opening 35.

Then, as shown in Fig. 13, for example, by CVD or the like, the additional silicon oxide layer 36 is formed in a thickness of 100 nm to 1000 nm so as to cover a surface of the silicon oxide layer 34 and an inner surface of the opening 35. To lower the softening temperature of the silicon oxide layer 36, an impurity such as boron or phosphorus may be added to the silicon oxide layer 36. Thereafter, the resulting semiconductor substrate assembly is processed by photolithography and etching, thereby removing the silicon germanium layer 32 to the additional silicon oxide layer 36 in the direction of thickness as well as removing a surface portion of the basis material 31 to manufacture a trim-like stacked structure.

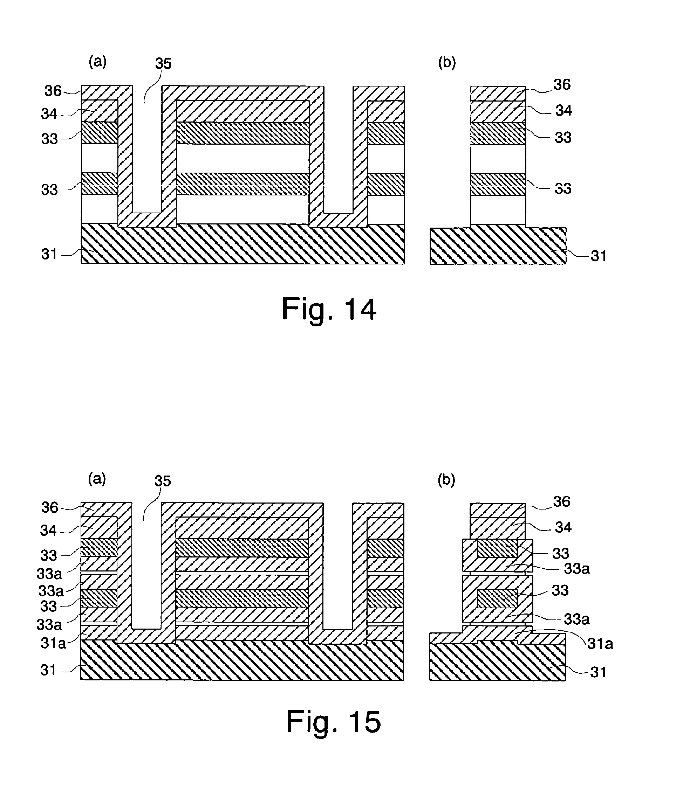

Then, as shown in Fig. 14, using the aforementioned nitrate fluoride based etchant, the semiconductor substrate assembly shown in Fig. 13 is subjected to an etching treatment, thereby removing only the silicon germanium layer 32. Additionally, in this case, the aforementioned ammonia / hydrogen peroxide based etchant may also be used. As dry etching, an oxygen / fluorine based gas may also be used for etching.

Then, as shown in Fig. 15, the semiconductor substrate assembly shown in Fig. 14 is subjected to a thermal oxidation treatment, thereby thermally oxidizing a surface portion of the basis material 31 and a surface portion of the silicon layer 33 to form the oxidized surface portions 31 a and 33a. The preferred characteristics required of the oxidized surface portions 31a and 33a are the same as those shown in Fig. 7.

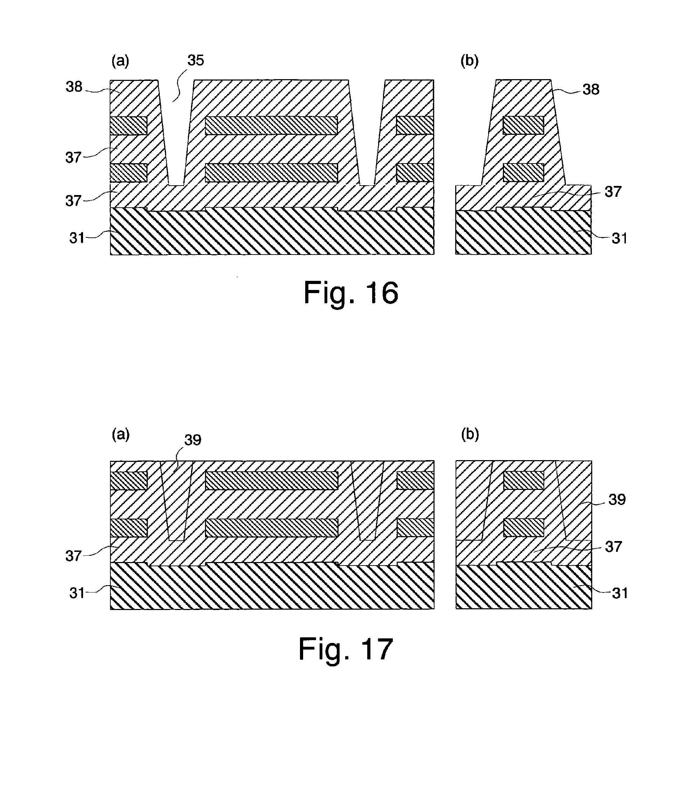

Then, as shown in Fig. 16, the semiconductor substrate assembly shown in Fig. 15 is subjected to an annealing treatment, thereby making the silicon oxide layer 36 soft to flow allowing the oxidized surface portion 33a to be brought into contact with the oxidized surface portion 31a and to be glued together to form the thermally oxidized silicon layer 37. At this time, two oxidized surface portions 33a overlying this are also brought into contact with each other and glued together, thus forming the thermally oxidized silicon layer 37. Additionally, the silicon oxide layers 34 and 36 are more firmly glued together to form the thermally oxidized silicon layer 38. The annealing treatment is preferably conducted within a temperature range of 850 deg. C to 1350 deg. C.

Then, as shown in Fig. 17, the silicon oxide film 39 is formed by CVD so as to bury the opening 35 of the semiconductor substrate assembly shown in Fig. 16, and then flattened by CMP or the like to thereby provide the semiconductor substrate 20 as shown in Fig. 2. The thickness of the upper and lower island parts may be changed.

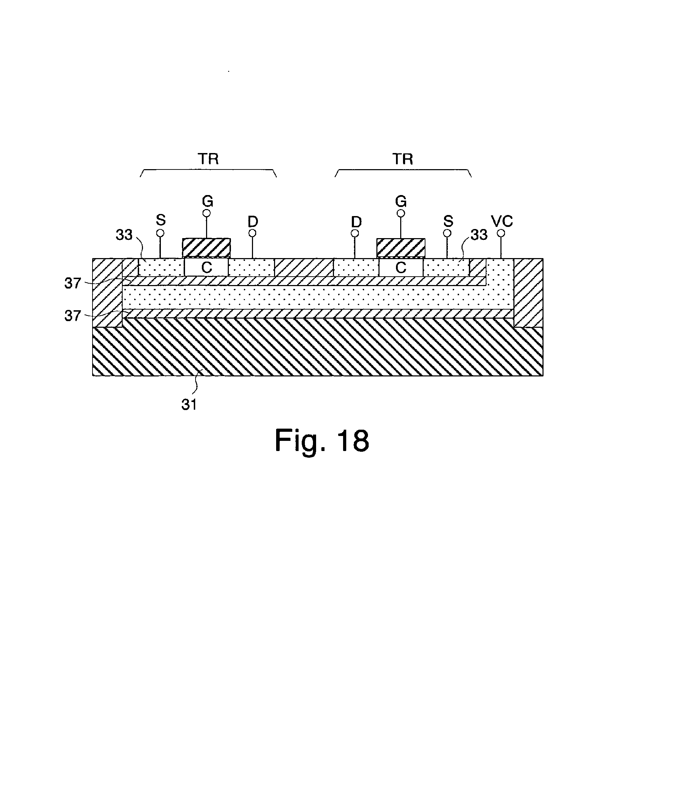

Fig. 18 shows a main portion of a semiconductor device manufactured using the semiconductor substrate of the second embodiment. The same components as those in the first embodiment (Fig. 10) are indicated by like reference symbols, and will not be repeatedly explained in detail. The semiconductor device has a plurality of MOS transistors TR manufactured on the upper silicon oxide layer 37 (BOX layer). The silicon layer 33 between the laminated silicon oxide layers 37 serves as a Vth control electrode VC for adjusting the threshold voltage of the transistors TR. In this embodiment, the voltage applied to the Vth control electrode VC can be changed, thereby adjusting the threshold voltage of the transistors TR. For example, the threshold voltage can be lowered when the transistor TR is operated, thereby increasing the operating speed of the transistor TR. The threshold voltage can be raised when the transistor TR is not operated, thereby reducing the OFF current (sub-threshold current) of the transistor TR. Accordingly, it is possible to design a high-speed, low power consumption semiconductor device. As in the first embodiment, the source region S, the drain region D, the gate electrode G, and the Vth control electrode VC are connected to the wiring manufactured on the transistor TR.

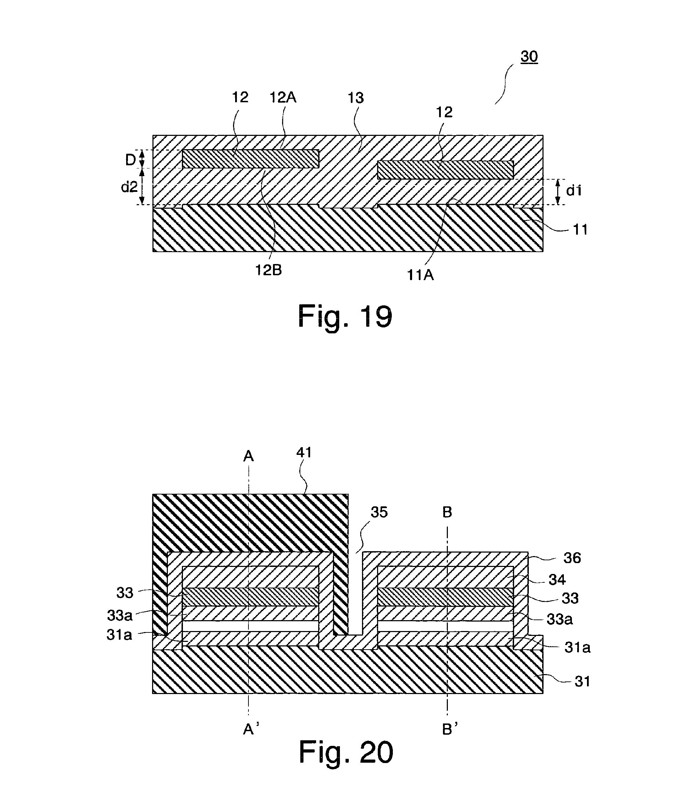

Fig. 19 is a schematic cross-sectional view showing a configuration according to a third embodiment of the present invention. The same components as those in the aforementioned first embodiment are indicated by like reference symbols and will not be repeatedly explained in detail. This semiconductor substrate 30 has BOX layers in a multiple types of thicknesses d 1 and d2 (d1 <d2). The island part 12 is formed in the same thickness D as in the first embodiment. At a plurality of island parts 12 on the BOX layer having a thermally oxidized silicon film of a thickness of d1 (first distance), for example, a MOS transistor having a short gate length is manufactured. At a plurality of island parts 12 on the BOX layer having a thermally oxidized silicon film of a thickness of d2 (second distance), for example, a MOS transistor having a long gate length and a high breakdown voltage is manufactured. The MOS transistor having a high breakdown voltage is required when designing a protection circuit (the input circuit or output circuit of an LSI) for preventing elements from being damaged due to surges or the like from an analog circuit or an external circuit. The present invention makes it possible to manufacture the semiconductor substrate 30 that includes BOX layers having different thicknesses through simple manufacturing processes, thus providing higher-performance analog / digital mixable LSIs (semiconductor devices) at lower manufacturing costs. It is also possible to easily manufacture MOS transistors having a high breakdown voltage. The third embodiment has the same effect as that of the aforementioned first embodiment.

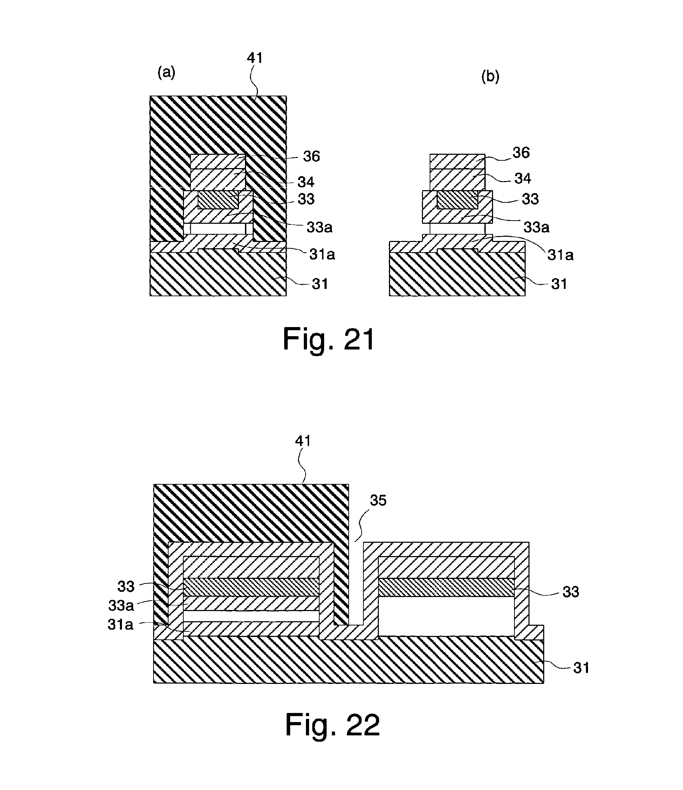

Fig. 20 to Fig. 24 are explanatory process diagrams showing a manufacturing method for the semiconductor substrate 30 shown in Fig. 17. First, after the processes of Fig. 3 to Fig. 7 of the aforementioned first embodiment have been completed, a photo-resist 41 is selectively formed, as shown in Fig. 20, to cover an area (or the area including the silicon layer 33 on the left in the figure) corresponding to the BOX layer that increases the thermally oxidized silicon film in thickness. Fig. 21 shows a cross section taken along the line A-A' and the line B-B' of Fig. 20. The oxidized surface portions 31a and 33a covered with the photo-resist 41 are not exposed to outside. Under this condition, for example, wet etching is carried out using a dilute hydrofluoric acid.

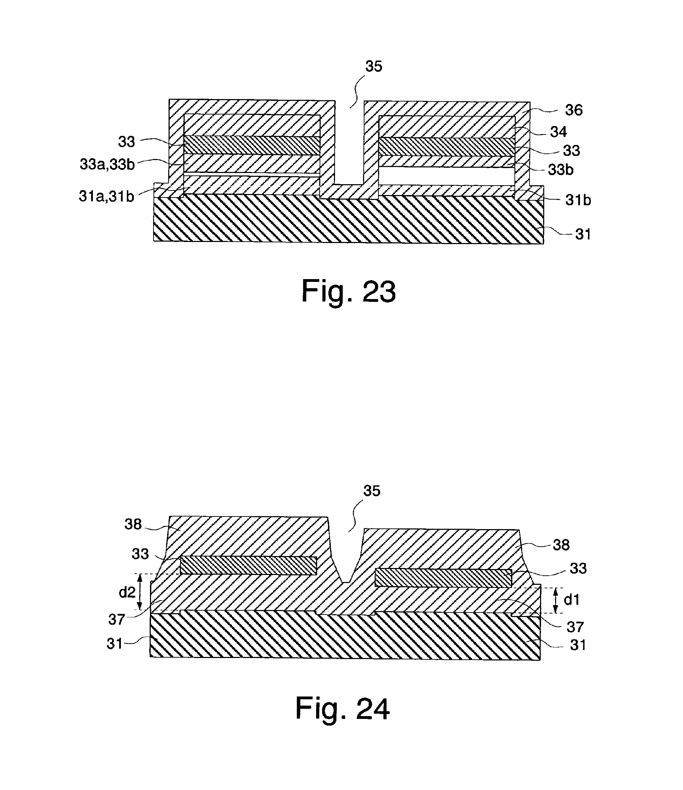

As shown in Fig. 22, by wet etching, the oxidized surface portions 31 a and 33a exposed to outside are removed, whereas the oxidized surface portions 31 a and 33a covered with the photo-resist 41 are not removed but remain. Then, as shown in Fig. 23, a thermal oxidation treatment is performed in the same manner as mentioned above with reference to Fig. 7 to thermally oxidize a surface portion of the basis material 31 and a surface portion of the silicon layer 33 opposed to the basis material 31, thereby forming new oxidized surface portions 31 b and 33b. At this time, the oxidized surface portions 31 b and 33b are thicker at the area covered with the photo-resist 41 in Fig. 20 but thinner at an area not covered with the photo-resist 41.

Then, as shown in Fig. 24, an annealing treatment is carried out in the same manner as mentioned above with reference to Fig. 8, and the silicon oxide layer 36 of Fig. 23 is made soft to flow allowing an oxidized surface portion 33b and an oxidized surface portion 31 b to be brought into contact with and glued to each other, thereby forming the thermally oxidized silicon layer 37. Thereafter, in the same manner as mentioned above with reference to Fig. 9, the opening 35 is filled with the silicon oxide film 39 by CVD, and then flattened by CMP or the like, thereby providing the semiconductor substrate 30 as shown in Fig. 19.

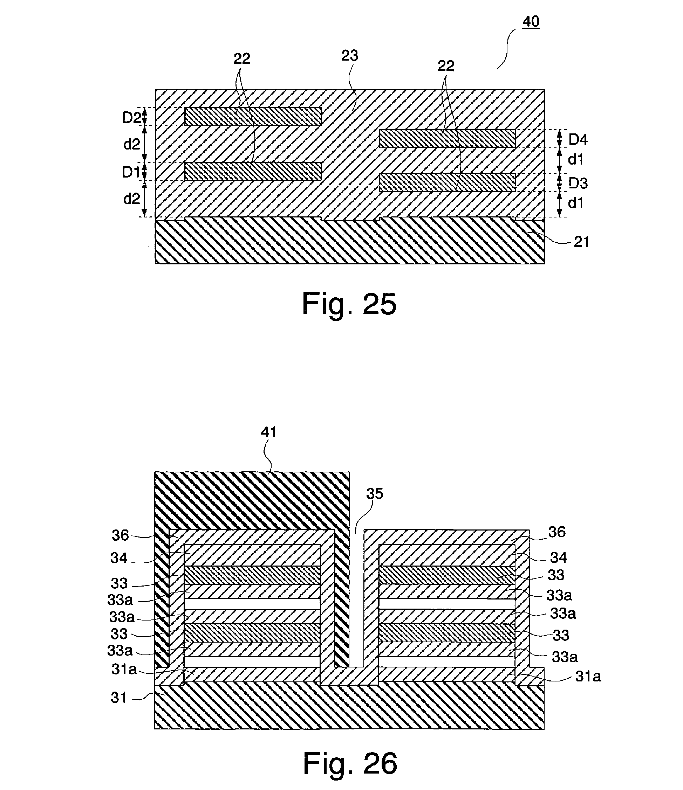

Fig. 25 is a schematic cross-sectional view showing a configuration according to a fourth embodiment of the present invention. The same components as those in the aforementioned second embodiment are indicated by like reference symbols and will not be repeatedly explained in detail. This semiconductor substrate 40 is configured to have laminated BOX layers of multiple types of thicknesses d 1 and d2 (d 1 <d2). The island parts 22 are formed in a thickness of D1 to D4, respectively. The thicknesses D1 to D4 are different depending on whether the island parts 22 are oxidized on both sides or one side as well as whether or not the oxide film is removed. In general, the thickness D2 is the largest, whereas the thickness D3 is the smallest. As in the aforementioned third embodiment, for example, a MOS transistor having a short gate length is formed at a plurality of island parts 22 on the upper BOX layer having a thermally oxidized silicon film of the thickness of d1. At a plurality of island parts 22 on the upper BOX layer having a thermally oxidized silicon film of the thickness d2, for example, formed is a MOS transistor having a long gate length and a high breakdown voltage. The semiconductor substrate 40 has the combined effects of both the second embodiment and the third embodiment.

Fig. 26 to Fig. 29 are explanatory process diagrams showing a manufacturing method for the semiconductor substrate 40 shown in Fig. 25. First, after the processes in Fig. 11 to Fig. 15 of the aforementioned second embodiment have been completed, the photo-resist 41 is selectively formed, as shown in Fig. 26, to cover an area (or the area including the silicon layer 33 on the left in the figure) corresponding to the BOX layer that increases the thermally oxidized silicon film in thickness. The oxidized surface portions 31a and 33a covered with the photo-resist 41 are not exposed to outside. Under this condition, for example, wet etching is carried out using a dilute hydrofluoric acid.

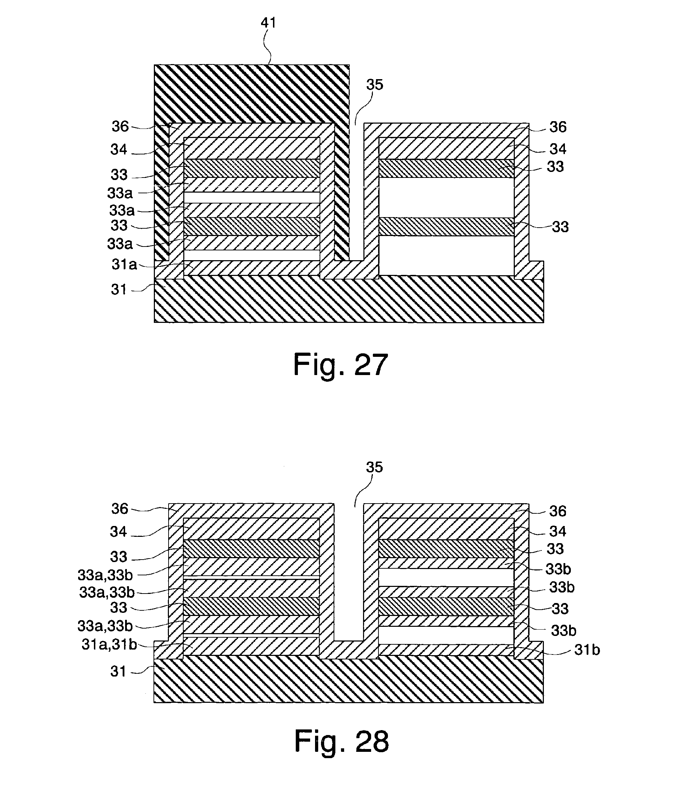

As shown in Fig. 27, by wet etching, the oxidized surface portions 31 a and 33a exposed to outside are removed, whereas the oxidized surface portions 31 a and 33a covered with the photo-resist 41 are not removed but remain. Then, as shown in Fig. 28, a thermal oxidation treatment is carried out in the same manner as mentioned above with reference to Fig. 15 to thermally oxidize a surface portion of the basis material 31 and a surface portion of the silicon layer 33 opposed to the basis material 31, thereby forming new oxidized surface portions 31 b and 33b. At this time, the oxidized surface portions 31 b and 33b are thicker at an area covered with the photo-resist 41 in Fig. 26 but thinner at an area not covered with the photo-resist 41.

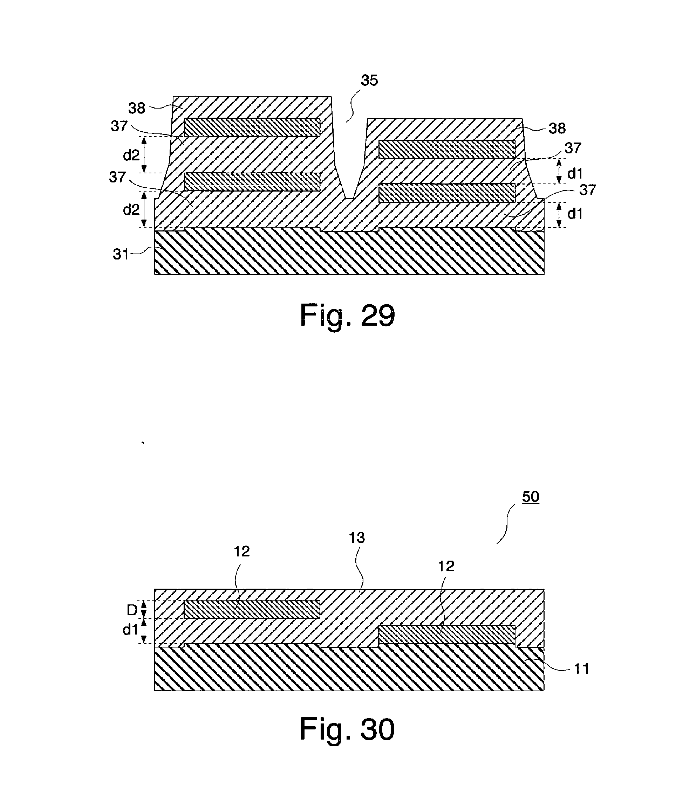

Then, as shown in Fig. 29, an annealing treatment is carried out in the same manner as mentioned above with reference to Fig. 16, and the silicon oxide layer 36 of Fig. 28 is made soft to flow allowing the oxidized surface portion 33b and the oxidized surface portion 31 b to be brought into contact with and glued to each other, thereby forming the thermally oxidized silicon layer 37. Thereafter, in the same manner as mentioned above with reference to Fig. 17, the opening 35 is filled with the silicon oxide film 39 by CVD, and then flattened by CMP or the like, thereby providing the semiconductor substrate 40 as shown in Fig. 25.

Fig. 30 is a schematic cross-sectional view showing a configuration according to a fifth embodiment of the present invention. The same components as those in the aforementioned first and third embodiments are indicated by like reference symbols and will not be repeatedly explained in detail. This semiconductor substrate 50 includes an area (on the left in the figure) having a BOX layer of the thickness of d 1 and an area (on the right in the figure) having no BOX layer formed therein. The area having the BOX layer serves as the so-called SOI area, whereas the area having no BOX layer formed therein serves as the so-called bulk area. That is, in this embodiment, the semiconductor substrate 50 can be employed partly as a SOI area or bulk area. The island part 12 (silicon layer) in the SOI area and the island part 12 in the bulk area are formed more than one, respectively.

In general, DRAMs are difficult to manufacture using a SOI substrate. For this reason, for example, a DRAM mixable image processing system LSI cannot use the SOI substrate and is thus manufactured using a typical silicon wafer. Alternatively, an image processing LSI and a DRAM are fabricated on separate chips (or an external DRAM is used). This is because the data retention time of the DRAM is reduced due to the use of the SOI substrate. More specifically, for the DRAM to retain data, there exist a static state in which the potential of the read bit line is not changed and a dynamic state in which the potential of the bit line is changed due to a read operation on another memory cell. In the dynamic state, the source-drain potential difference of a transfer transistor in a memory cell varies in response to a change in the potential of the bit line. An increase in body potential resulting from a junction leak causes a sub-threshold leak due to a change in the potential of the bit line, thus reducing the data retention time. Application of the present invention makes it possible to manufacture a DRAM mixable system LSI using the bulk area formed within the SOI substrate. Accordingly, it is possible to prevent degradation in DRAM data retention characteristics and thus provide an improved performance to the system LSI. More specifically, the operating frequency of the system LSI can be improved or its power consumption can be reduced.

To manufacture this semiconductor substrate 50, for example, after the processes of the aforementioned third embodiment in Fig. 22 have been completed, the process shown in Fig. 23 is not followed but the annealing treatment shown in Fig. 24 is carried out to eliminate the gap between the island part 12 (silicon film) and the silicon basis material 11. Then, in the same manner as mentioned above with reference to Fig. 9, the opening 35 is filled with the silicon oxide film 39 by CVD and flattened by CMP or the like, thereby manufacturing the semiconductor substrate 50.

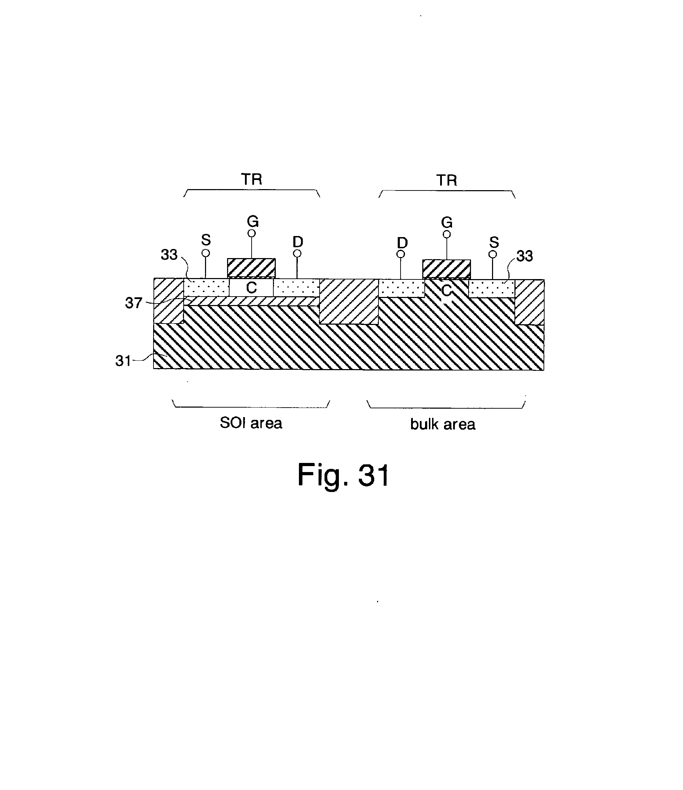

Fig. 31 shows a main portion of a semiconductor device manufactured using the semiconductor substrate of a sixth embodiment. The same components as those in the first embodiment (Fig. 10) are indicated by like reference symbols and will not be repeatedly explained in detail. In this embodiment, transistors TR are manufactured at a SOI area (on the left in the figure) and a bulk area (on the right in the figure), respectively. The transistors TR are simultaneously manufactured using the same fabrication process. For example, a logic circuit is manufactured at the SOI area, while a DRAM is manufactured at the bulk area. That is, a logic-memory mixable LSI is manufactured. Additionally, a logic circuit can also be formed at the SOI area, thereby providing enhanced resistance to surges.

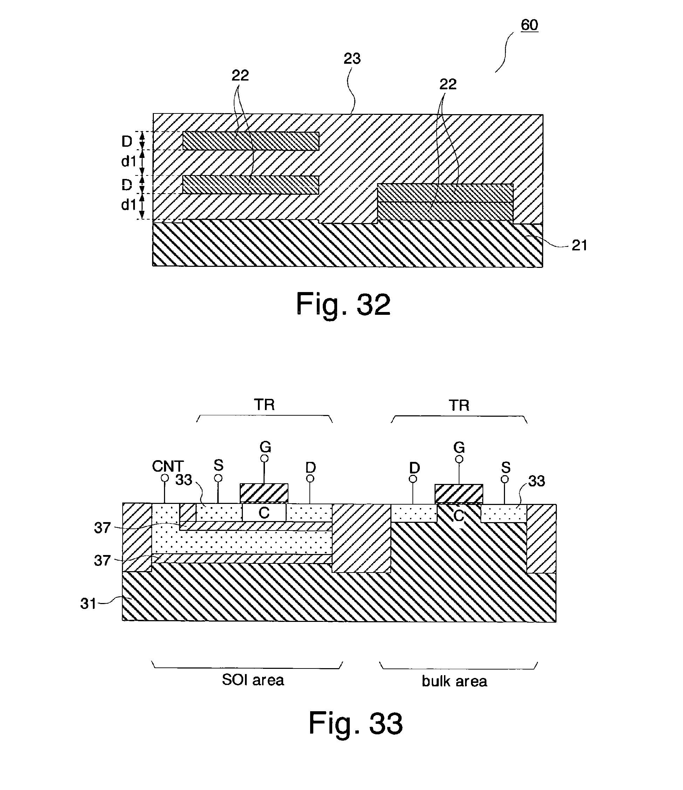

Fig. 32 is a schematic cross-sectional view showing a configuration according to the sixth embodiment of the present invention. The same components as those in the aforementioned second and fourth embodiments are indicated by like reference symbols and will not be repeatedly explained in detail. This semiconductor substrate 60 includes an area having a plurality of laminated BOX layers of the thickness of d 1 and an area having no BOX layer formed therein. In the same manner as in the fifth embodiment, the area (on the left in the figure) having the BOX layer serves as the so-called SOI area, whereas the area (on the right in the figure) having no BOX layer formed therein serves as the so-called bulk area. The island part 12 (silicon layer) in the SOI area and the island part 12 in the bulk area are formed more than one, respectively. In the same manner as in the fifth embodiment, application of the present invention makes it possible to manufacture a DRAM mixable system LSI using the SOI substrate and provide an improved performance to the system LSI.

To manufacture the semiconductor substrate 60, for example, after the processes of the aforementioned fourth embodiment in Fig. 27 have been completed, the process shown in Fig. 28 is not followed but the annealing treatment shown in Fig. 29 is carried out to eliminate the gap between the island part 12 (silicon film) and the silicon basis material 12. Then, in the same manner as mentioned above with reference to Fig. 17, the opening 35 is filled with the silicon oxide film 39 by CVD and flattened by CMP or the like, thereby manufacturing the semiconductor substrate 60.
Fig. 33 shows a main portion of a semiconductor device manufactured using the semiconductor substrate of the fifth embodiment. The same components as those in the first embodiment (Fig. 10) and the second embodiment (Fig. 18) are indicated by like reference symbols and will not be repeatedly explained in detail. In this embodiment, transistors TR are manufactured at a SOI area (on the left in the figure) and a bulk area (on the right in the figure), respectively. Both the transistors TR are simultaneously manufactured using the same fabrication process. Furthermore, for the transistor TR at the SOI area, the voltage applied to the Vth control electrode VC can be changed, thereby adjusting the threshold voltage of the transistor TR in the same manner as in the second embodiment. Accordingly, it is possible to design a high-speed, low power consumption logic and memory mixable LSI.

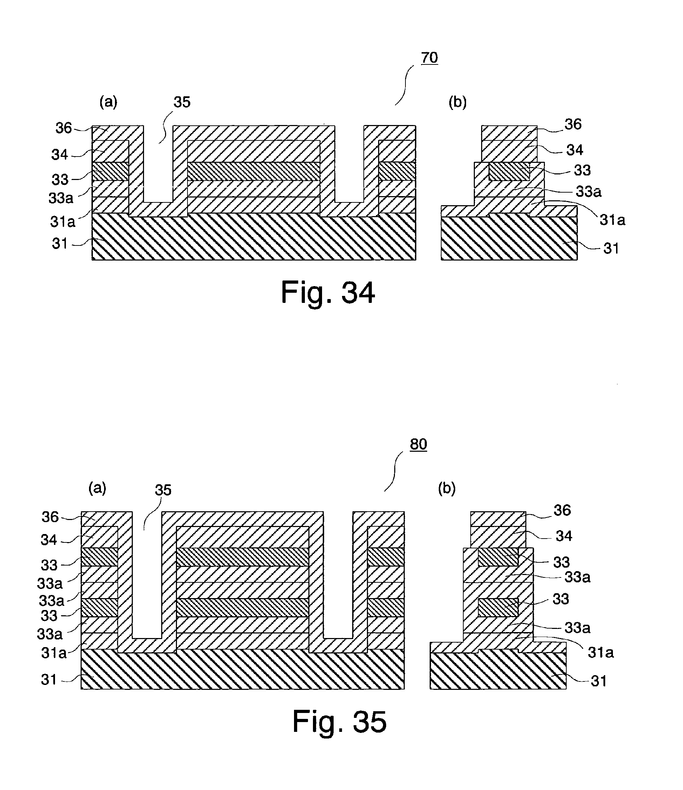

Fig. 34 is a cross-sectional view showing a process of manufacturing a semiconductor substrate according to a seventh embodiment of the present invention. The same components as those in the aforementioned first embodiment are indicated by like reference symbols and will not be repeatedly explained in detail. This semiconductor substrate 70 is manufactured in the same processes as those for the semiconductor substrate 10 of the first embodiment excluding the process of manufacturing the BOX layer. The completed semiconductor substrate 70 is the same as the semiconductor substrate 10. Accordingly, the seventh embodiment has the same effect as that of the first embodiment.

To manufacture the semiconductor substrate 70, first, the processes of the first embodiment shown in Fig. 3 to Fig. 6 are carried out. Then, the process of the first embodiment in Fig. 7 (thermal oxidation treatment) is carried out until the oxidized surface portions 31a and 33a are brought into contact with each other. At this time, the thermal oxidation treatment (wet O₂ oxidation) is carried out at 700 to 800 deg. C using the so-called reaction determining area in order to make the BOX layer uniform in thickness. Then, as shown in Fig. 33, after the oxidized surface portions 31 a and 33a have been brought into contact with each other, an annealing treatment is carried out in the same manner as mentioned above with reference to Fig. 8 to glue the oxidized surface portions 31a and 33a to each other. Thereafter, in the same manner as mentioned above with reference to Fig. 9, the opening 35 is filled with the silicon oxide film 39 by CVD and flattened by CMP or the like, thereby providing the semiconductor substrate 70 that is the same as that of Fig. 1. Without conducting the annealing treatment, the oxidized surface portions 31a and 33a may be further oxidized and glued together after the oxidized surface portions 31a and 33a have been brought into contact with each other.

Fig. 35 is a cross-sectional view showing a process of manufacturing a semiconductor substrate according to an eighth embodiment of the present invention. The same components as those in the aforementioned second embodiment are indicated by like reference symbols and will not be repeatedly explained in detail. This semiconductor substrate 90 is manufactured in the same processes as those for the semiconductor substrate 20 of the second embodiment excluding the process of manufacturing the BOX layer. The completed semiconductor substrate 80 is the same as the semiconductor substrate 20. Accordingly, the eighth embodiment has the same effect as that of the second embodiment.

To manufacture the semiconductor substrate 80, first, the processes of the second embodiment shown in Fig. 11 to Fig. 14 are carried out. Then, the process of the second embodiment in Fig. 15 (thermal oxidation treatment) is carried out until the oxidized surface portions 31a and 33a are brought into contact with each other. At this time, in the same manner as in the seventh embodiment, the thermal oxidation treatment (wet O₂ oxidation) is carried out at 700 to 800 deg. C using the so-called reaction determining area in order to make the BOX layer uniform in thickness. Then, as shown in Fig. 35, after the oxidized surface portions 31a and 33a have been brought into contact with each other, an annealing treatment is carried out in the same manner as mentioned above with reference to Fig. 16 to glue the oxidized surface portions 31 a and 33a to each other. Thereafter, in the same manner as mentioned above with reference to Fig. 17, the opening 35 is filled with the silicon oxide film 39 by CVD and flattened by CMP or the like, thereby providing the semiconductor substrate 80 that is the same as that of Fig. 2. In the same manner as in the aforementioned seventh embodiment, without conducting the annealing treatment, the oxidized surface portions 31a and 33a may be further oxidized and glued together after the oxidized surface portions 31a and 33a have been brought into contact with each other.

In the case of the conventional UNIBOND and ELTRAN, a plurality of wafers had to be sequentially affixed one on another in manufacturing a semiconductor substrate having island parts in multi-layers as shown in Fig. 2. Thus, this made the process very intricate (requiring the number of fabrication processes for the island part in one layer times the number of the multi-layers), thus causing an increase in fabrication costs. In contrast to this, according to the aforementioned manufacturing method of the present invention, only an additional simple process of additionally providing a silicon germanium layer and a silicon layer would make it possible to easily form a semiconductor substrate having the intended multi-layer island parts.

In the aforementioned embodiments, the silicon oxide layer 36 may also be configured in multi-layers where the silicon oxide film is sandwiched between thin pieces of polysilicon (or amorphous silicon). In this case, at the time of etching the silicon germanium layer 32 (e.g., Fig. 6 and Fig. 14), the silicon oxide layer 36 exposed to a space, from which the silicon germanium layer 32 has been removed, can be prevented from being etched,. The polysilicon or amorphous silicon will change to a silicon oxide through the subsequent thermal oxidation treatment.

Furthermore, during the annealing treatment at 850 deg. C to 1350 deg. C in the aforementioned embodiments (e.g., Fig. 8 and Fig. 16), a pressure may be applied onto the wafers, when necessary, to firmly glue the oxidized surface portion 31a and 33a together. At this time, the pressure can be generated by placing one wafer on another or by blowing a gas onto the wafer.

The invention is not limited to the above embodiments and various modifications may be made without departing from the spirit and scope of the invention. Any improvement may be made in part or all of the components.

## Claims

1. A semiconductor substrate comprising:
a basis material made of silicon, having a surface with an uneven part formed thereon; and
a plurality of island parts made of silicon, electrically insulated from said basis material as well as from each other above a convex part of said basis material.

2. The semiconductor substrate according to Claim 1, further comprising
an insulation component formed between said basis material and said island parts and composed of two layers.

3. The semiconductor substrate according to Claim 1, wherein
said plurality of island parts are formed in a single plane generally parallel to a main surface of said basis material.

4. The semiconductor substrate according to Claim 1, wherein
said plurality of island parts are formed in a plurality of planes generally parallel to the main surface of said basis material, and formed in a multi-stage above the convex part of said basis material.

5. The semiconductor substrate according to Claim 4, further comprising
an insulation component formed between said island parts laminated on top of each other and composed of two layers.

6. The semiconductor substrate according to any one of Claims 1 to 5, wherein
said plurality of island parts are buried in the insulation component provided on said basis material.

7. The semiconductor substrate according to Claim 6, wherein
said insulation component is made of silicon oxide.

8. The semiconductor substrate according to Claims 1 to 7, wherein
distances between a main surface of said basis material facing to said island parts and main surfaces of said island parts facing to said basis material are different from each other.

9. The semiconductor substrate according to Claim 8, wherein
the semiconductor substrate is composed of an island part located at the distance as a first distance and an island part located at the distance as a second distance.

10. The semiconductor substrate according to any one of Claims 1 to 7, comprising
an island part made of silicon, being in contact with said basis material and electrically insulated from the island parts which are electrically insulated from said basis material.

11. The semiconductor substrate according to Claim 8 or 10, wherein:
said plurality of island parts are formed in a multi-stage above each of the convex parts; and
the multi-stage island parts are different from each other in thickness.

12. The semiconductor substrate according to any one of Claims 1 to 7, wherein
the distances between the main surface of said basis material facing to said island parts and the main surfaces of said island parts facing to said basis material are 3 nm to 200 nm.

13. The semiconductor substrate according to any one of Claims 1 to 7, wherein
the distances between the main surfaces of said island parts facing to said basis material and the main surfaces of said island parts located on an opposite side of said basis material are 2 nm to 150 nm.

14. The semiconductor substrate according to any one of Claims 1 to 13, wherein
said island parts are formed as a strained silicon layer.

15. A semiconductor device comprising the semiconductor substrate according to any one of Claims 1 to 14.

16. A manufacturing method for a semiconductor substrate, comprising the steps of:
preparing a basis material made of silicon;
forming a silicon germanium layer on said basis material;
forming a silicon layer on said silicon germanium layer;
forming a silicon oxide layer on said silicon layer;
removing said silicon germanium layer to said silicon oxide layer by photolithography and etching in a direction of thickness as well as removing a surface portion of said basis material, to form a plurality of openings;
forming an additional silicon oxide layer so as to cover said silicon oxide layer and inner surfaces of said plurality of openings;
removing said silicon germanium layer to said additional silicon oxide layer in a direction of thickness by photolithography and etching as well as removing an upper surface portion of said basis material, to form a trim-like stacked structure;
selectively removing said silicon germanium layer by etching;
performing a thermal oxidation treatment on said stacked structure to oxidize a surface portion of said basis material and a surface portion of said silicon layer facing to said basis material; and
forming an insulator film on a thermally oxidized silicon layer of the surface portion of said basis material and performing a flat treatment thereon.

17. The manufacturing method for a semiconductor substrate according to Claim 16, comprising the step of:
between the thermal oxidation treatment and the flat treatment, performing an annealing treatment on said stacked structure, and bonding an oxidized surface portion of said basis material to an oxidized surface portion of said silicon layer by softening and fluidizing said additional silicon oxide layer, thereby forming a thermally oxidized silicon layer.

18. The manufacturing method for a semiconductor substrate according to Claim 16, further comprising the steps of:
between the thermal oxidation treatment and the flat treatment;
selectively removing said oxide film in an area corresponding to a predetermined island part;
forming an oxide film through an thermal oxidation treatment on a surface portion of said basis material and a surface portion of said silicon layer facing to said basis material in areas corresponding to all of the island parts; and
performing an annealing treatment on said stacked structure, and bonding an oxidized surface portion of said basis material to an oxidized surface portion of said silicon layer by softening and fluidizing said additional silicon oxide layer, thereby forming a thermally oxidized silicon layer.

19. The manufacturing method for a semiconductor substrate according to Claim 16, further comprising the steps of:
between the thermal oxidation treatment and the flat treatment;
selectively removing said oxide film in an area corresponding to a predetermined island part; and
performing an annealing treatment on said stacked structure, and bonding an oxidized surface portion of said basis material to an oxidized surface portion of said silicon layer by softening and fluidizing said additional silicon oxide layer, thereby forming a thermally oxidized silicon layer and bonding an island part corresponding to a removed oxide film to said basis material.

20. A manufacturing method for a semiconductor substrate, comprising the steps of:
preparing a basis material made of silicon:
alternately laminating a plurality made of silicon germanium layers and a plurality of silicon layers on said basis material so that said silicon germanium layer is located at a bottom and said silicon layer is located at a top;
forming a silicon oxide layer on a silicon layer located at the top;
removing said silicon germanium layer located at the bottom to said silicon oxide layer by photolithography and etching in a direction of thickness as well as removing a surface portion of said basis material, to form a plurality of openings;
forming an additional silicon oxide layer so as to cover said silicon oxide layer and inner surfaces of said plurality of openings;
removing the silicon germanium layer located at the bottom to said additional silicon oxide layer by photolithography and etching in a direction of thickness as well as removing an upper surface portion of said basis material, to form a trim-like stacked structure;
selectively removing said plurality of silicon germanium layers by etching;
performing a thermal oxidation treatment on said stacked structure to oxidize a surface portion of said basis material and a surface portion of said plurality of silicon layers; and
forming an insulator film on a thermally oxidized silicon layer of the surface portion of said basis material and performing a flat treatment thereon.

21. The manufacturing method for a semiconductor substrate according to Claim 20, further comprising the step of
between the thermal oxidation treatment and the flat treatment,
performing an annealing treatment on said stacked structure, and bonding an oxidized surface portion of said basis material to an oxidized surface portion of said silicon layer facing to said basis material by softening and fluidizing said additional silicon oxide layer and bonding oxidized surface portions of adjacent plurality of silicon layers to each other, to form a thermally oxidized silicon layer.

22. The manufacturing method for a semiconductor substrate according to Claim 20, further comprising the steps of:
between the thermal oxidation treatment and the flat treatment;
selectively removing said oxide film in an area corresponding to a predetermined island part to be laminated;
forming an oxide film through a thermal oxidation treatment on a surface portion of said basis material and a surface portion of said silicon layer facing to said basis material in areas corresponding to all of the island parts; and
performing an annealing treatment on said stacked structure, and bonding an oxidized surface portion of said basis material to an oxidized surface portion of said silicon layer facing to said basis material by softening and fluidizing said additional silicon oxide layer, to form a thermally oxidized silicon layer.

23. The manufacturing method for a semiconductor substrate according to Claim 20, comprising further comprising the steps of:
between the thermal oxidation treatment and the flat treatment,
selectively removing said oxide film in an area corresponding to a predetermined island part to be laminated; and
performing an annealing treatment on said stacked structure, bonding an oxidized surface portion of said basis material to an oxidized surface portion of said silicon layer facing to said basis material by softening and fluidizing said additional silicon oxide layer to form a thermaiiy oxidized silicon layer, and bonding a plurality of island parts corresponding to a removed oxide film to each other and bonding, to said basis material, the island parts on the basis material side corresponding to a removed oxide film.

24. The manufacturing method for a semiconductor substrate according to any one of Claims 16 to 23, further comprising the step of including a dopant in said plurality of silicon germanium layers.

25. The manufacturing method for a semiconductor substrate according to Claim 24 wherein said dopant is boron (B).

26. The manufacturing method for a semiconductor substrate according to any one of Claims 16 to 25, wherein
a concentration of germanium in said silicon germanium layer is 5% to 50.

27. The manufacturing method for a semiconductor substrate according to any one of Claims 16 to 26, wherein
said silicon germanium layer is removed using a nitrate fluoride based etchant.

28. The manufacturing method for a semiconductor substrate according to any one of Claims 16 to 27, wherein
said thermal oxidation treatment is a wet process.

29. The manufacturing method for a semiconductor substrate according to any one of Claims 16 to 28, wherein
said annealing treatment is performed at 850 deg. C to 1350 deg. C.

30. The manufacturing method for a semiconductor substrate according to any one of Claims 16 to 29, wherein
said insulator film formed on the thermally oxidized silicon layer of the surface portion of said basis material is made of silicon oxide.

31. The manufacturing method for a semiconductor substrate according to any one of Claims 16 to 30, wherein
said silicon layer is formed as a strained silicon layer.

32. A manufacturing method for a semiconductor device comprising the manufacturing method according to any one of Claims 16 to 31.
